# EUROPEAN PATENT APPLICATION

(11) **EP 2 079 112 A1**
(43) Date of publication of application: **15.07.2009**
(21) Application number: 08100225.5
(22) Date of filing: 08.01.2008
(51) Int. Cl.: H01L 31/052

(54) **Radiating apparatus for solar cell**

(71) Applicant: Atomic Energy Council - Institute of Nuclear Energy Research, Lungtan, Taoyuan, Taiwan (TW)
(72) Inventor: Hong, Hwen-Fen, 333, CHIAAN VILLAGE, LUNGTAN, TAOYUAN (TW); Shih, Zun-Hao, 333, CHIAAN VILLAGE, LUNGTAN, TAOYUAN (TW); Chen, Ying-Ru, 333, CHIAAN VILLAGE, LUNGTAN, TAOYUAN (TW); Shin, Hwa-Yuh, 333, CHIAAN VILLAGE, LUNGTAN, TAOYUAN (TW); Kuo, Cherng, Tsong, 333, CHIAAN VILLAGE, LUNGTAN, TAOYUAN (TW)
(74) Representative: Beck & Rössig European Patent Attorneys

(57) **Abstract**

A solar cell pack includes a solar cell for converting light into electricity, a circuit layer attached to the solar cell for transferring the electricity from the solar cell to a storage apparatus and radiating apparatus for radiating heat from the solar cell and the circuit layer. The radiating apparatus includes a radiator and a multi-purpose layer. The multi-purpose layer attaches the radiator to the circuit layer, isolates the radiator from the circuit layer and transfers heat to the radiator from the circuit layer in operation.

## Description

### BACKGROUND OF INVENTION

### 1. FIELD OF INVENTION

The present invention relates to a solar cell and, more particularly, to a radiating apparatus for a solar cell.

### 2. RELATED PRIOR ART

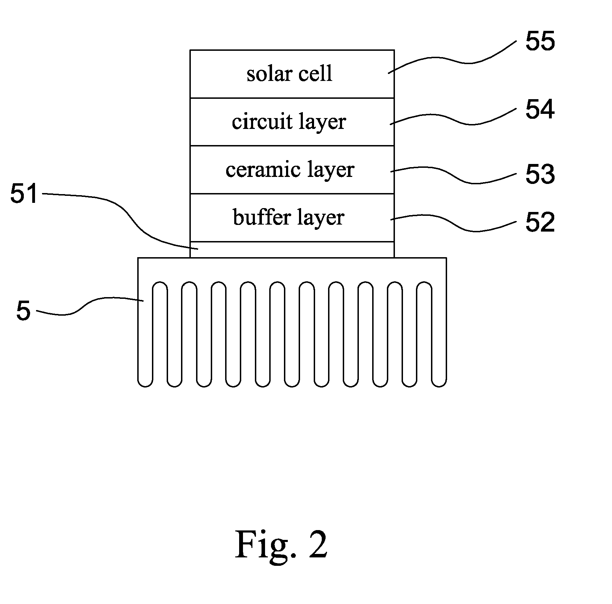

Referring to Fig. 2, a solar cell 55 is provided on a circuit layer 54. The circuit layer 54 is provided on a ceramic layer 53. The ceramic layer 53 is provided on a buffer layer 52. Heat-conducting grease 51 is provided between the buffer layer 52 and a radiator 5. The heat-conducting grease 51 is used for adhering or bonding the radiator 5 to the buffer layer 52 as well as for conducting heat to the radiator 5 from the buffer layer 52.

In operation, the solar cell 55 converts sunlit into electricity. The circuit layer 54 carries a circuit for transferring the electricity to a storage apparatus such as a battery. The solar cell 55 and the circuit layer 54 inevitably generate heat. The heat is conducted to the radiator 5 via the ceramic layer 53, the buffer layer 52 and the heat-conducting grease 51. Finally, the heat is radiated from the radiator 5. The temperature gets lower from the solar cell 55 to the radiator 5. Yet, the temperature is still high in the heat-conducting grease 51 because the heat is generated in a large amount. The high temperature would eventually cause the heat-conducting grease 51 to deteriorate and lose the ability to adhere the radiator 5 to the buffer layer 52.

The present invention is therefore intended to obviate or at least alleviate the problems encountered in prior art.

### SUMMARY OF INVENTION

It is the primary objective of the present invention to provide a durable radiating apparatus for a solar cell.

The present invention provides a solar cell pack comprising the features of claim 1. Advantageous embodiments are laid down in further claims.

A solar cell pack according to the invention includes a solar cell for converting light into electricity, a circuit layer attached to the solar cell for transferring the electricity from the solar cell to a storage apparatus and radiating apparatus for radiating heat from the solar cell and the circuit layer. The radiating apparatus includes a radiator and a multi-purpose layer. The multi-purpose layer attaches the radiator to the circuit layer, isolates the radiator from the circuit layer and transfers heat to the radiator from the circuit layer in operation.

Other objectives, advantages and features of the present invention will become apparent from the following description referring to the attached drawings.

### BRIEF DESCRIPTION OF DRAWINGS

The present invention will be described via detailed illustration of a preferred embodiment referring to the drawings.
Fig. 1 is a side view of a solar cell, a circuit layer and a radiating apparatus according to the preferred embodiment of the present invention.
Fig. 2 is a side view of a solar cell, a circuit layer, a ceramic layer, a buffer layer and a conventional radiating apparatus.

### DETAILED DESCRIPTION OF PREFERRED EMBODIMENT

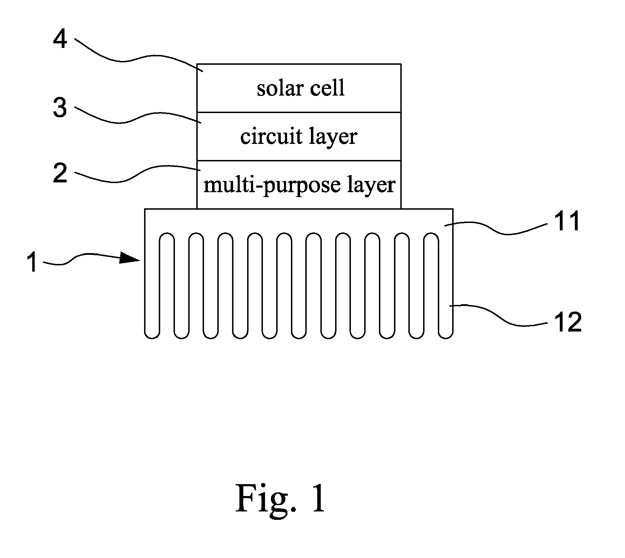

Referring to Fig. 1, a solar cell 4 is provided on a circuit layer 3, and the circuit layer 3 is provided on a radiating apparatus according to the preferred embodiment of the present invention. The radiating apparatus includes a radiator 1 and a multi-purpose layer 2 provided between the radiator 1 and the circuit layer 3.

The radiator 1 includes a plate 11 and a plurality of fins 12 extending from the plate 11. The radiator 1 may be made of copper or an aluminum-nickel alloy.

The multi-purpose layer 2 is used for at least three purposes. Firstly, it attaches the radiator 1 to the circuit layer 3. Secondly, it electrically isolates the circuit layer 3 from the radiator 1. Thirdly, it conducts heat from the circuit layer 3 to the radiator 1. The multi-purpose layer 2 is made of a nanometer plasticized material.

The solar cell 4 is of course used to convert sunlit to electricity. The circuit layer 3 carries a circuit for transferring the electricity from the solar cell 4 to a storage apparatus such as a battery. The circuit layer 3 is made of metal.

As made of the nanometer plasticized material, the multi-purpose layer 2 survive temperature that would be too high for conventional heat-conducting grease to stand. The multi-purpose layer 2 is durable. Therefore, the radiation of the heat from the solar cell 4 and the circuit layer 3 is reliable. The he solar cell 4 and the circuit layer 3 are always used in a proper range of temperature.

The present invention has been described via the detailed illustration of the preferred embodiment. Those skilled in the art can derive variations from the preferred embodiment without departing from the scope of the present invention. Therefore, the preferred embodiment shall not limit the scope of the present invention defined in the claims.

## Claims

1. A solar cell pack comprising:
a solar cell (4) for converting light into electricity;
a circuit layer (3) attached to the solar cell for transferring the electricity from the solar cell to a storage apparatus; and
a radiating apparatus comprising a radiator (1) and a multi-purpose layer (2) for attaching the radiator to the circuit layer, for isolating the radiator from the circuit layer and for transferring heat to the radiator from the circuit layer.

2. The solar cell pack according to claim 1 wherein the a radiator comprises:
a plate in contact with the multi-purpose layer; and
a plurality of fins extending from the plate.

3. The solar cell pack according to claim 1 or 2, wherein the radiator is made of copper.

4. The solar cell pack according to claim 1 or 2, wherein the radiator is made of an aluminum-nickel alloy.

5. The solar cell pack according to one of claims 1 to 4, wherein the multi-purpose layer is made of a nanometer plasticized material.
